**Europäisches Patentamt**

**European Patent Office**

**Office européen des brevets**

(19)

(11) Veröffentlichungsnummer: **0 030 993**

**A1**

(12) ## EUROPÄISCHE PATENTANMELDUNG

(21) Anmeldenummer: **80100910.1**

(22) Anmeldetag: **25.02.80**

(51) Int. Cl.³: **H 05 K 7/10**
**H 05 K 7/12, G 09 B 23/18**

(30) Priorität: **20.12.79 DE 2951308**

(43) Veröffentlichungstag der Anmeldung:
**01.07.81 Patentblatt 81/26**

(84) Benannte Vertragsstaaten:
**AT BE CH FR GB IT LU NL SE**

(71) Anmelder: **Heinrich Schwarz & Co., inh. G. Herfurth**
**Hebelstrasse 2**
**D-8500 Nürnberg(DE)**

(72) Erfinder: **Sojka, Joachim**
**Bahnhofstrasse 15**
**D-8544 Gräfenberg(DE)**

(74) Vertreter: **Patentanwälte Czowalla . Matschkur +**
**Partner**
**Königstrasse 1**
**D-8500 Nürnberg(DE)**

(54) **Aufbauplatte für einen elektrischen oder elektronischen Baukasten.**

(57) Bei dieser Aufbauplatte ist eine Isolierplatte (2) zur Herstellung einer gedruckten Schaltung einseitig mit metallischen Leiterbahnen (3) versehen. Zum lötfreien Verbinden der Anschlußdrähte elektronischer Bauteile ist die Aufbauplatte an den jeweiligen Anschlußstellen mit durchgehenden Bohrungen (6) versehen, in die aus einem Kopf (9) und zwei davon ausgehenden Federschenkeln (10) bestehende Klemmfedern einrastbar sind. Infolge der durch die Kröpfungen (15) der Federschenkel (10) bewirkten Verrastung wird der Kopf (9) unter Kontaktgabe an die Leiterbahn (3) angepreßt, so daß bei der Herstellung der gewünschten Verbindungen lediglich die Anschlußdrähte der elektronischen Bauteile zwischen den jeweiligen Federschenkeln (10) festgeklemmt werden müssen.

FIG. 3

**0030993**

Dr. Max Schneider † (1977)
Dr. Alfred Eitel    Dipl.-Ing.
Ernst Czowalla    Dipl.-Ing.
                  Dipl.-Ldw.
Peter Matschkur   Dipl.-Phys.

Patentanwälte

Zugelassen beim Europäischen Patentamt - admitted to the European Patent Office - agréés près l'Office européen des brevets

85 Nürnberg 106, den
Königstraße 1 (Museumsbrücke)
Fernsprech-Sammel-Nr. 20 39 31

P Parkhaus Katharinenhof
  Parkhaus Adlerstraße

unser Zeichen: 30 120-14/Bae

- 1 -

Aufbauplatte für einen elektrischen oder elektronischen Baukasten

Die Erfindung bezieht sich auf eine Aufbauplatte für einen elektrischen oder elektronischen Baukasten, auf der Anschlußdrähte elektrischer Bauteile an leitenden Klemmfedern festklemmbar sind.

Eine derartige bekannte Aufbauplatte ist mit einer Anzahl rechteckiger Öffnungen versehen, an deren Rand sich senkrecht zur Ebene der Aufbauplatte erstreckende Seitenwände angeformt sind, wobei die durch diese Seitenwände gebildeten Schächte der Aufnahme und Halterung der Klemmfedern dienen. Die Klemmfedern sind dabei U-förmig ausgebildet, wobei der U-Steg jeweils die Fläche der Öffnung einnimmt und die beiden U-Schenkel sich jeweils an den beiden breiten Seiten des Schachtes abstützen. Ferner sind die beiden U-Schenkel an ihren freien Enden ins Innere der U-Form zum U-Steg hin abgebogen und unter Bildung einzelner Federzungen geschlitzt. Der U-Steg weist eine der Anzahl dieser Federzungen entsprechende Anzahl von Bohrungen auf, durch die die Anschlußdrähte der elektrischen Bauteile sowie auch die nötigen Verbindungsdrähte in das Innere der U-Form zwischen die durch die gegen die Seitenwände des Schachtes abgestützten U-Schenkel gegenseitig unter Federdruck gehaltenen Federzungen einführbar und dort festklemmbar sind.

Neben dem hohen Herstellungsaufwand, den diese Aufbauplatte und die darin gehalterten Klemmfedern verursachen, ist es hierbei ferner nachteilig, daß außer dem Festklemmen der einzelnen elektrischen Bauteile in den entsprechenden Klemmfedern bei der Herstellung einer bestimmten Schaltung auch noch die nötigen Verbindungsleitungen zwischen den isoliert voneinander in der Aufbauplatte gehalterten Klemmfedern einzeln angebracht und festgeklemmt werden müssen.

Zwar sind gedruckte Schaltplatten bekannt, bei denen alle erforderlichen Verbindungsleitungen bereits als Leiterbahnen auf eine isolierende Tragplatte aufgedruckt sind, so daß hierbei das mühsame Anbringen einzelner Verbindungsleitungen zwischen den entsprechenden elektrischen Bauteilen entfällt. Doch müssen dabei die Anschlußdrähte an den Anschlußstellen mit den Leiterbahnen verlötet werden, was der Verwendung der gedruckten Schaltplatte bei einem insbesondere für Anfänger gedachten Baukasten entgegensteht, da das sachgemäße Herstellen sowie auch Lösen der erforderlichen Lötverbindungen eine zu hohe Anforderung an den Benutzer des Baukastens darstellt.

Der Erfindung liegt die Aufgabe zugrunde, eine Aufbauplatte der eingangs genannten Art zu schaffen, die einfacher herstellbar ist und bei der unter Vermeidung der vorerwähnten Schwierigkeiten lediglich die Anschlußdrähte der elektrischen Bauteile ohne die Notwendigkeit weiterer Verbindungsleitungen in einfacher Weise an den Klemmfedern der Aufbauplatte festgeklemmt werden müssen.

Erfindungsgemäß wird diese Aufgabe dadurch gelöst, daß die Aufbauplatte als eine mit gedruckten Leiterbahnen versehene Schaltplatte und die Klemmfeder mit einem Kopf und zwei davon ausgehenden, sich gegenüberstehenden Federschenkeln ausgebildet ist, die durch Bohrungen an den Anschlußstellen der Schaltplatte hindurchführbar und dort unter elektrischer Kontaktgabe durch Anlage des Kopfes auf der jeweiligen Leiterbahn verrastbar sind, wobei die Anschlußdrähte zwischen den beiden aus der Schaltplatte herausragenden Federschenkeln festklemmbar sind.

Durch die erfindungsgemäße Verwendung der mit gedruckten Leiterbahnen versehenen Schaltplatte werden alle sonst zwischen den elektrischen Bauteilen erforderlichen Verbindungsdrähte vermieden, so daß neben einer guten Übersichtlichkeit der Aufbau einer bestimmten Schaltung sehr rasch durchgeführt werden kann. Dennoch vermeidet die Erfindung die bei gedruckten Schaltplatten sonst erforderlichen Lötverbindungen für die Anschlußdrähte der elektrischen Bauteile, indem an den Anschlußstellen der Schaltplatte Bohrungen vorgesehen sind, in die die erfindungsgemäß ausgebildeten Klemmfedern verrastend einsetzbar sind. Dabei liegt zur Herstellung der elektrischen Kontaktgabe der Kopf der Klemmfeder auf der jeweiligen Leiterbahn an der einen Seite der Schaltplatte auf, wogegen die beiden sich gegenüberstehenden Federschenkel auf der anderen Seite der Schaltplatte aus der Bohrung herausragen und durch ihren gegenseitigen Federdruck die Anschlußdrähte zwischen sich festzuklemmen vermögen. Sowohl die Schaltplatte als auch die Klemmfedern sind einfach herstellbar und können vom Benutzer des Baukastens leicht gehandhabt werden. Um einen Anschlußdraht an einer bestimmten Anschlußstelle festzulegen, braucht nur durch die an dieser Anschlußstelle vorgefertigte Bohrung eine der Klemmfedern durch Fingerdruck eingesetzt zu werden, worauf diese Anschlußstelle zum Festklemmen des entsprechenden Anschlußdrahtes vorbereitet ist.

Dabei erweist es sich als besonders vorteilhaft, daß die Klemmfeder aus einer einstückig gebogenen Federlänge besteht, die von ihrer Mitte aus unter Bildung des Kopfes kreisförmig zusammengebogen und an der Nahtstelle des Kreisumfanges zur Kreismitte hin abgebogen sowie dort unter Bildung der beiden Federschenkel senkrecht zur Kreisebene abgewinkelt ist. Die derart ausgebildete Klemmfeder ist besonders einfach und kostensparend herzustellen und zeigt auch bezüglich ihrer Klemmwirkung günstige Eigenschaften.

In einer weiteren vorteilhaften Ausgestaltung der Erfindung ist ferner wenigstens einer der Federschenkel im Abstand der Dicke der Schaltplatte vom Kopf mit einer Kröpfung als Rastnase versehen. Nachdem die solchermaßen ausgebildete Klemmfeder in die Bohrung der Schaltplatte eingeführt ist, stützt sich die Rastnase gegen die dem Kopf abgewandte Seite der Schaltplatte ab und übt somit über den durch die Bohrung hindurchgeführten Teil des gekröpften Federschenkels auf den Kopf einen Zug in Richtung zur mit der Leiterbahn versehenen Seite der Schaltplatte aus. Die hierdurch erreichte sichere Kontaktgabe und feste Halterung der Klemmfeder läßt sich noch weiter dadurch verbessern, daß die beiden Federschenkel mit der Kröpfung versehen und die beiden Kröpfungen einander entgegengesetzt angeordnet sind.

Schließlich erweist es sich noch als sehr zweckmäßig, daß die Federschenkel in Richtung ihrer freien Enden geringfügig auseinanderlaufen. Eine derartige Ausbildung erleichtert nämlich das Festklemmen der Anschlußdrähte, indem diese ohne weiteres zwischen die leicht auseinanderweichenden freien Enden der Federschenkel eingeführt und zur Herstellung des Klemmsitzes in Richtung des Kopfes verschoben werden können.

Weitere Merkmale, Einzelheiten und Vorteile der Erfindung ergeben sich aus der folgenden Beschreibung einer Ausführungsform und anhand der Zeichnung. Hierin zeigen:

Fig. 1 eine perspektivische Ansicht einer Schaltplatte mit herausragenden Federschenkeln eingesetzter Klemmfedern,

Fig. 2 die in Fig. 1 dargestellte Schaltplatte in perspektivischer Ansicht von ihrer anderen Seite,

Fig. 3 einen Detail-Querschnitt durch die Schaltplatte mit eingesetzter Federklemme und

Fig. 4 eine perspektivische Ansicht der Federklemme.

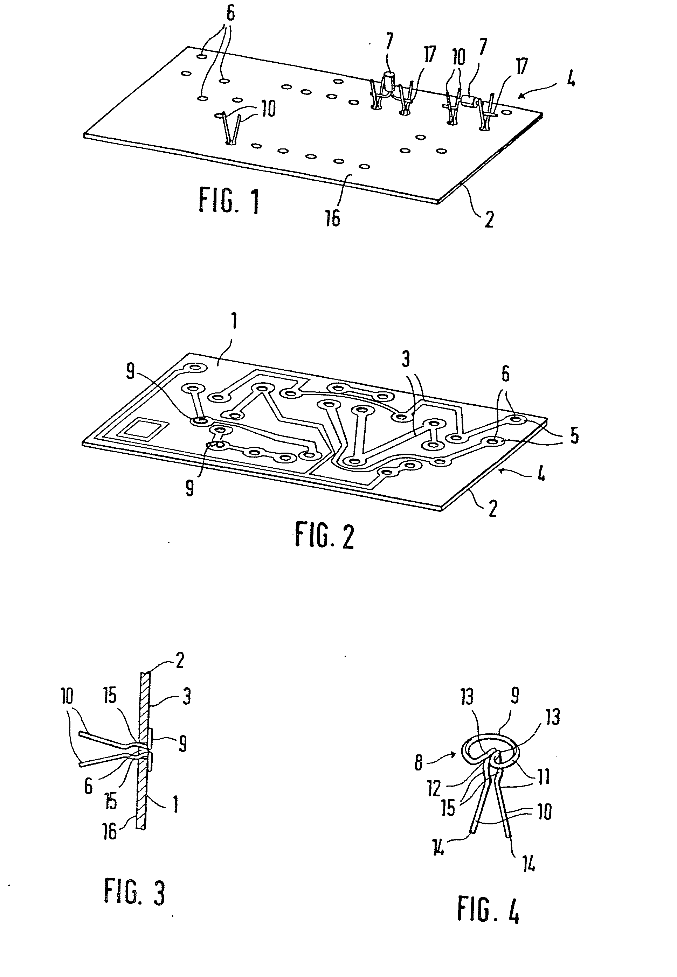

Wie aus Fig.1 und 2 hervorgeht, sind auf der Rückseite 1 einer Isolierplatte 2 metallische Leiterbahnen 3 aufgedruckt.

Die hierdurch gebildete Schaltplatte 4 ist an Anschlußstellen 5 mit durchgehenden Bohrungen 6 versehen, welche die Isolierplatte 2 sowie die aufliegende Leiterbahn 3 völlig durchsetzen.

Damit bei der Verwendung der Schaltplatte 4 als Aufbauplatte für einen elektrischen oder elektronischen Baukasten der Anschluß entsprechender elektrischer oder elektronischer Bauteile 7 erfolgen kann, werden in die Bohrungen 6 der betroffenen Anschlußstellen gemäß Fig. 3 jeweils Klemmfedern 8 eingesetzt. Diese Klemmfedern 8 bestehen gemäß Fig. 4 aus einem Kopf 9 und zwei davon ausgehenden Federschenkeln 10, wobei dieser Kopf und die Federschenkel aus einer Federdrahtlänge 11 einstückig gebogen sind.

Dabei ist gemäß Fig. 4 die Federdrahtlänge 11 von ihrer Mitte aus unter Bildung des Kopfes 9 kreisförmig zusammengebogen. Ferner ist die Federdrahtlänge 11 an der hierdurch gebildeten Nahtstelle 12 des Kreisumfanges beidseitig zur Mitte hin abgebogen, wodurch zwei in etwaparallele radiale Stege 13 gebildet werden, die bis zur Mitte des Kreises reichen. Dort ist die Federdrahtlänge 11 nochmals abgewinkelt und erstreckt sich unter Bildung der beiden Federschenkel 10 senkrecht zur Kreisebene. Die sich gegenüberstehenden Federschenkel 10 weichen, wie in den Fig. 3 und 4 übertrieben dargestellt ist, in Richtung ihrer freien Enden 14 geringfügig auseinander.

Die beiden Federschenkel 10 sind ferner ungefähr im Abstand der Dicke der Schaltplatte 4 vom Kopf 9 mit je einer Kröpfung 15 versehen, wobei diese beiden Kröpfungen einander entgegengesetzt sind, indem die beiden im Bereich ihres Ausgangspunktes an den radialen Stegen 13 aneinander anliegenden Federschenkel 10 zur Bildung der Kröpfung 15 auseinander- und dann in Richtung der freien Enden 14 wieder zusammenlaufen.

Wie Fig. 3 deutlich zeigt, rastet die Klemmfeder 8 mit Hilfe der Kröpfungen 15 in der Bohrung 6 fest ein, wobei durch die im Bereich der Kröpfung 15 auseinanderweichenden Bereiche der Federschenkel 10 auf den Kopf 9 eine Zugkraft ausgeübt wird, durch die dieser fest gegen die Leiterbahn 3 unter elektrischer Kontaktgabe angedrückt wird.

Zwischen die auf der Rückseite 16 der Schaltplatte 4 herausragenden Federschenkel 10 der eingerasteten Klemmfeder 8 werden nun zur Herstellung einer bestimmten Schaltung Anschlußdrähte 17 der Bauteile 7, bei denen es sich beispielsweise um Widerstände, Kondensatoren, Dioden, Transistoren od.dgl. handelt, festgeklemmt, wobei durch das Auseinanderweichen der freien Enden 14 der Festklemmvorgang erleichtert wird, indem die Anschlußdrähte 17 von diesen freien Enden her leicht in den durch die Federkraft zwischen den Federschenkeln 10 bewirkten Klemmsitz eingeführt werden können. Durch das Festklemmen der Anschlußdrähte 17 zwischen den Federschenkeln 10 wird sowohl ein hinreichend stabiler mechanischer Aufbau der Schaltung erreicht als auch eine sichere und leicht wieder lösbare Kontaktgabe, wie es für den baukastenmäßigen Aufbau einer Schaltung von großer Bedeutung ist.

Vorteilhaft ist der eine Federschenkel 10 etwas kürzer als der andere gehalten. In diesem Fall können nämlich durch Andrücken eines Anschlußdrahtes 17 an den längeren Federschenkel 10 unter leichtem Druck diese beiden Federschenkel 10 besser gespreizt werden, was das Einklemmen des Anschlußdrahtes 17 erleichtert.

Patentansprüche

1. Aufbauplatte für einen elektrischen oder elektronischen Baukasten, auf der Anschlußdrähte elektrischer Bauteile an leitenden Klemmfedern festklemmbar sind, dadurch gekennzeichnet, daß die Aufbauplatte als eine mit gedruckten Leiterbahnen (3) versehene Schaltplatte (4) und die Klemmfeder (8) mit einem Kopf (9) und zwei davon ausgehenden, sich gegenüberstehenden Federschenkeln (10) ausgebildet ist, die durch Bohrungen (6) an den Anschlußstellen (5) der Schaltplatte (4) hindurchführbar und dort unter elektrischer Kontaktgabe durch Anlage des Kopfes (9) auf der jeweiligen Leiterbahn (3) verrastbar sind, wobei die Anschlußdrähte (17) zwischen den beiden aus der Schaltplatte (4) herausragenden Federschenkeln (10) festklemmbar sind.

2. Aufbauplatte nach Anspruch 1, dadurch gekennzeichnet, daß die Klemmfeder (8) aus einer einstückig gebogenen Federdrahtlänge (11) besteht, die von ihrer Mitte aus unter Bildung des Kopfes (9) kreisförmig zusammengebogen und an der Nahtstelle (12) des Kreisumfanges zur Kreismitte hin abgebogen sowie dort unter Bildung der beiden Federschenkel (10) senkrecht zur Kreisebene abgewinkelt ist.

3. Aufbauplatte nach Anspruch 1 oder 2, dadurch gekennzeichnet, daß wenigstens einer der Federschenkel (10) im Abstand der Dicke der Schaltplatte (4) vom Kopf (9) mit einer Kröpfung (15) als Rastnase versehen ist.

4. Aufbauplatte nach Anspruch 3, dadurch gekennzeichnet, daß die beiden Federschenkel (10) mit der Kröpfung (15) versehen und die beiden Kröpfungen (15) einander entgegengesetzt angeordnet sind.

5. Aufbauplatte nach einem der Ansprüche 1 bis 4, dadurch gekennzeichnet, daß die Federschenkel (10) in Richtung ihrer freien Enden (14) geringfügig auseinanderlaufen.

6. Aufbauplatte nach einem der Ansprüche 1 bis 5, dadurch gekennzeichnet, daß der eine der beiden divergierenden Federschenkel (10) etwas kürzer ist als der andere.

FIG. 1

FIG. 2

FIG. 3

FIG. 4

Nummer der Anmeldung

EP 80 10 0910.1

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - U - 7 209 341 (KLEIN)<br>* Ansprüche 1, 4, Seite 5,<br>  Zeile 6 bis Seite 6, Zeile 16;<br>  Fig. 1, 2, 4, 5 *<br>-- | 1,5 |
| | US - A - 3 115 381 (HOAG)<br>* Spalte 1, Zeile 55 bis Spalte 2,<br>  Zeile 49; Fig. 1 bis 6 *<br>-- | 1,3,4 |
| A | DE - B2 - 2 337 326 (SIEMENS)<br>* Spalte 3, Zeile 45 bis Spalte 4,<br>  Zeile 49; Fig. 1 bis 4 *<br>-- | |
| A | US - A - 3 093 431 (LEWIS)<br>* Spalte 2, Zeilen 37 bis 63;<br>  Fig. 1 bis 5 *<br>---- | |

**KLASSIFIKATION DER ANMELDUNG (Int. Cl.³)**

H 05 K 7/10
H 05 K 7/12
G 09 B 23/18

**RECHERCHIERTE SACHGEBIETE (Int. Cl.³)**

G 09 B 23/18
H 01 R 4/48
H 05 K 1/11
H 05 K 7/02
H 05 K 7/06
H 05 K 7/08
H 05 K 7/10
H 05 K 7/12

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde
   liegende Theorien oder
   Grundsätze
E: kollidierende Anmeldung
D: in der Anmeldung angeführtes
   Dokument
L: aus andern Gründen
   angeführtes Dokument
&: Mitglied der gleichen Patentfamilie, übereinstimmendes
   Dokument

X Der vorliegende Recherchenbericht wurde für alle Patentansprüche erstellt.

| Recherchenort | Abschlußdatum der Recherche | Prüfer |
|---|---|---|
| Berlin | 11-03-1981 | HAHN |

EPA form 1503.1 06.78